# Europäisches Patentamt
## European Patent Office
### Office européen des brevets

(19)

(11) Veröffentlichungsnummer: **0 139 027**
**B1**

(12) # EUROPÄISCHE PATENTSCHRIFT

(45) Veröffentlichungstag der Patentschrift:
**16.03.88**

(51) Int. Cl.⁴: **H 01 L 27/08**, H 01 L 29/86

(21) Anmeldenummer: **83110415.3**

(22) Anmeldetag: **19.10.83**

(54) **Monolithisch integrierte Schaltung mit mindestens einem integrierten Widerstand.**

(43) Veröffentlichungstag der Anmeldung:
**02.05.85 Patentblatt 85/18**

(45) Bekanntmachung des Hinweises auf die Patenterteilung:
**16.03.88 Patentblatt 88/11**

(84) Benannte Vertragsstaaten:
**DE FR NL**

(56) Entgegenhaltungen:
FR-A-2 351 505
GB-A-1 563 194
US-A-3 700 977
US-A-4 371 847

IBM TECHNICAL DISCLOSURE BULLETIN, Band 8,
Nr. 12, Mai 1966, Seiten 1849-1850, New York, USA;
H.R. GATES: "Semiconductor resistor"

(73) Patentinhaber: **Deutsche ITT Industries GmbH, Hans- Bunte- Strasse 19 Postfach 840, D-7800 Freiburg (DE)**
(84) Benannte Vertragsstaaten: **DE**

(73) Patentinhaber: **ITT INDUSTRIES INC., 320 Park Avenue, New York, NY 10022 (US)**
(84) Benannte Vertragsstaaten: **FR NL**

(72) Erfinder: **Lang, Manfred, Breitenfeldstrasse 27, D-7832 Kenzingen (DE)**

(74) Vertreter: **Stutzer, Gerhard, Dr., Deutsche ITT Industries GmbH Patent- und Lizenzabteilung Hans- Bunte- Strasse 19 Postfach 840, D-7800 Freiburg (DE)**

LIBER, STOCKHOLM 1988

EP 0 139 027 B1

**Beschreibung**

Die Erfindung beschäftigt sich mit der Ausbildung von integrierten Widerständen in monolithisch integrierten Schaltungen, wie sie aus der Zeitschrift "Scientia electrica" (1969) Heft 1, Seiten 17 bis 34 bekannt sind. Solche Widerstände werden in bipolaren integrierten Schaltungen bei einer der Diffusionen, wie sie zur Herstellung einer der Zonen von integrierten Planartransistoren durchgeführt werden, einzeln oder in der Mehrzahl in eine sogenannte Wanne, welche gegen den übrigen Teil der integrierten Schaltung durch eine PN-Übergangsfläche abgegrenzt ist, diffundiert. An der Wanne wird gewöhnlich ein Kontakt angebracht, um den PN-Übergang der PN-Übergangsfläche in allen vorkommenden Betriebsfällen gesperrt zu halten.

Der Erfindung liegt das Problem der Nichtlinearität von integrierten Widerständen zugrunde, wie es ausführlich in der DE-OS-30 09 042 beschrieben wird. Dieses Problem besteht darin, daß sich der Widerstandswert mit Schwankungen der am Widerstand anliegenden Spannung aufgrund der Änderung der Raumladungszone entlang dem Widerstand unter Umständen beträchtlich ändert. Solche Umstände ergeben sich insbesondere bei R-2R-Netzwerken für D/A-Wandler mit höherer Bitzahl von etwa mehr als 8 Bit. Berücksichtigt man nämlich, daß beim Anlegen von Spannungen zwischen 0 und 1 V an einen herkömmlichen integrierten Widerstand, ohne Anwendung der in der DE-OS-30 09 042 genannten Maßnahme, die Widerstandswerte eines solchen integrierten Widerstandes um 1 bis 2 % schwanken können, so leuchtet ein, daß die Realisierung eines D/A-Wandlers höherer Bitzahl unter den oben genannten Umständen schwierig wird.

Als Lösung des vorstehend geschilderten Probleme wird nach der Lehre der oben genannten DE-OS-30 09 042 an den Mittelpunkt des integrierten Widerstandes ein Kontakt angebracht, der mit der Wanne verbunden wird. Dies hat aber den Nachteil, daß ein in Durchlaßrichtung vorgespannter Widerstandsabschnitt entsteht, so daß beispielsweise schon bei einer Spannung von 1 V vier Widerstände mit ihren voneinander getrennten Wannen hintereinander geschaltet werden müssen, um die Durchlaßrichtung zu vermeiden.

Diese bekannte Lösung zur Bewältigung von "höheren" Spannungen hat jedoch den Nachteil eines erheblichen Platz- und Kontaktierungsaufwandes. Pro Volt sind bei dem erwähnten Beispiel mit vier integrierten Widerständen vier Wannen mit 16 Kontakten erforderlich, so daß Schwankungen der Kontaktwiderstände unter Umständen erheblich in den Gesamtwiderstand eingehen.

Aufgabe der Erfindung ist daher die Angabe einer platzsparenden und von Schwankungen der Kontaktwiderstände kaum abhängigen Lösung des bekannten Problems der nichtlinearen Spannungsabhängigkeit eines monolithisch integrierten Widerstandes für Spannungsabfälle oberhalb von etwa 0,5 V.

Die Erfindung geht von dem Gedanken aus, zur Lösung dieser Aufgabe den aus der Zeitschrift "IBM Technical Disclosure Bulletin" Bd. 8, Nr. 12 (Mai 1966) Seiten 1849 und 1850 bekannten integrierten Widerstand zu verwenden, an dessen Wanne, welche in eine Oberflächenseite eines Substrats des Leitungstyps des Widerstandes eingesetzt ist, zwei Kontakte angebracht sind, so daß der Ausgang einer Strom- oder Spannungsquelle an die Wanne anlegbar ist. Das Anbringen eines zweiten Kontaktes an der Wanne des bekannten integrierten Widerstandes erfolgt aber hier zur Realisierung eines weiteren integrierten Widerstandes, der mittels einer PN-Übergangsfläche von dem Widerstandsmaterial des ersten integrierten Widerstandes getrennt ist. Bei einer Verwendung der beiden integrierten Widerstände liegt natürlich an beiden Widerständen eine Potentialdifferenz an.

Die Erfindung macht nun Verwendung von der aus der vorstehend genannten Literaturstelle bekannten Anordnung eines integrierten Widerstandes in einer integrierten Schaltung gemäß dem Gattungsbegriff des Anspruchs 1, allerdings zur Lösung des aus der oben genannten DE-OS-30 09 042 bekannten Problems der Nichtlinearität von solchen integrierten Widerständen.

Der Erfindung liegt der Gedanke zugrunde, an die Wanne eines integrierten Widerstandes eine solche Spannung anzulegen, daß der Spannungsverlauf des integrierten Widerstandes weitgehend bis auf eine konstante Potentialdifferenz angenähert ist.

Die oben genannte Aufgabe wird somit bei der bekannten monolithisch integrierten Schaltung gemäß dem Oberbegriff des Anspruch 1 durch die im kennzeichnenden Teil angegebene Erfindung gelöst.

An das Kontaktpaar der Wanne, das in Längserstreckung des integrierten Widerstandes liegt, wird also die Ausgangsspannung einer Strom- oder Spannungsquelle angelegt, deren Ausgangsspannung zumindest während des Flusses eines Stromes durch den integrierten Widerstand einen von dem Stromfluß des Widerstandes getrennten Stromfluß in der Wanne bewirkt.

Bei integrierten Schaltungen mit geschalteten Widerstandsnetzwerken, insbesondere Digital/Analog-Spannungswandlern, ist es von besonderem Vorteil, die Wanne eines integrierten Widerstandes an eine Spannungsquelle zu legen, welche zum gleichen Zeitpunkt wie die Widerstände des Neztwerkes geschaltet wird und zudem die gleiche Spannung liefert wie die an den Wiederständen des Netzwerkes anliegende. Dementsprechend wird das Kontaktpaar der Wanne in den Stromkreis einer schaltbaren Strom- oder Spannungsquelle gelegt, welche gleichzeitig mit dem Stromfluß durch den integrierten Widerstand schaltbar ist.

Die optimale Widerstands- und Stromverteilung der Wannen eines Widerstandsnetzwerkes wird ohne weiteres entsprechend einer Weiterbildung der Erfindung dadurch erhalten, daß die Widerstände dieses Widerstandsnetzwerkes einzeln oder mehrfach in die eine Wanne einer Wannenstruktur eingesetzt ist bzw. sind, die der Widerstandsnetzwerkstruktur weitgehend ähnlich ist. Dadurch ist gewährleistet, daß der Potentialverlauf der Wannenstruktur dem der Widerstandsnetzwerkstruktur ähnelt und auf diese Weise auch hinsichtlich der einzelnen Widerstände der Potentialverlauf der entsprechenden Wanne dem des einzelnen integrierten Widerstandes weitgehend bis auf eine konstante Potentialdifferenz entsprechend der Erfindung angenähert ist. Aus einer gleichen Ähnlichkeitsbetrachtung sollte auch das Wannennetzwerk mittels Schaltern in gleicher Weise wie das Widerstandsnetzwerk schaltbar sein. Das Wannen-Netzwerk eines R/2R-Netzwerkes für einen D/A-Spannungswandler sollte daher in gleicher Weise geschaltet werden wie das R/2R-Netzwerk.

Eine besonders vorteilhafte Anwendung des integrierten Widerstandes nach der Erfindung ergibt sich daher bei der Realisierung des monolithisch integrierten Widerstandsnetzwerkes eines monolithisch integrierten D/A-Wandlers.

Die Erfindung und ihre vorteilhafte Anwendungen werden im folgenden anhand der Zeichnungen erläutert, deren

Fig. 1 zur Erläuterung der Erfindung anhand eines einzelnen in einer Wanne untergebrachten integrierten Widerstandes dient, deren

Fig. 2 das Schaltbild eines D/A-Stromwandlers für neun Bit zeigt, bei dem die Erfindung mit Vorteil anwendbar ist, deren Fig. 3 die Auslegung der Struktur eines R-2R-Netzwerkes in der Wannenstruktur eines monolithisch integrierten D/A-Spannungswandlers veranschaulicht und deren

Fig. 4 ein entsprechendes Schaltbild mit einer schaltbaren Wannenstruktur entsprechend der Erfindung zeigt.

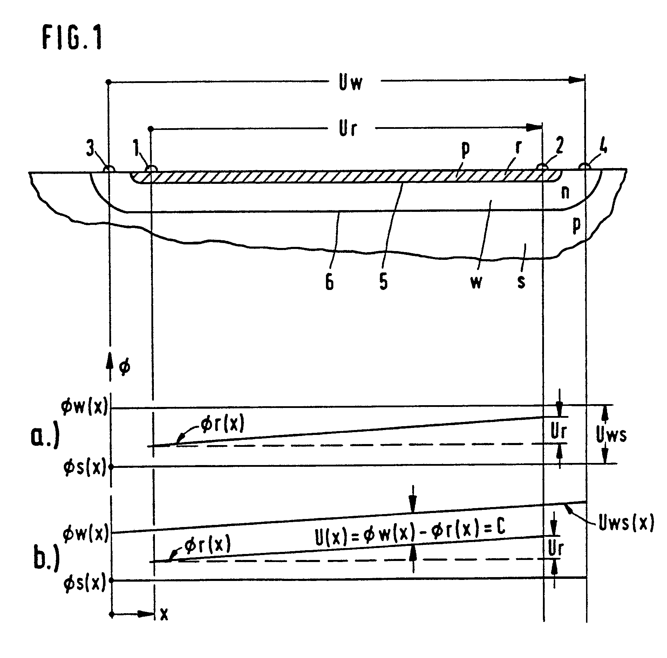

Die Fig. 1 zeigt die Anordnung eines integrierten Widerstandes r mit seiner Wanne w in einer Oberflächenseite des Substrates s vom ersten Leitungstyp des integrierten Widerstandes r, also beispielsweise vom P-Leitungstyp entsprechend der Fig. 1. Zur Bildung von elektrisch trennenden PN-Übergangsflächen 5 bzw. 6 einerseits zwischen dem integrierten Widerstand r und der Wanne p und andererseits zwischen Wanne w und dem Substrat s erhält die Wanne w Dotierungen vom zweiten Leitungstyp, also n-dotierende Verunreinigungen entsprechend den Angaben in der Fig. 1.

An dem integrierten Widerstand r sind die Kontakte 1 und 2 eines ersten Kontaktpaares angebracht. Zur Anlegung eines geeigneten Potentials, welches gewährleistet, daß die PN-Übergänge im Betrieb stets in Sperrichtung vorgespannt sind, erhält die Wanne w normalerweise lediglich einen Kontakt. Aus der eingangs genannten Literaturstelle ist jedoch bekannt, auch einen zweiten Kontakt anzubringen, um die Wanne w selbst als zweiten integrierten Widerstand zu verwenden. Eine solche Verwendung allein bedingt aber noch nicht, daß die bekannte Anordung für die Zwecke der Erfindung brauchbar ist.

Vielmehr müssen die beiden Kontaktpaare 1, 2 und 3, 4 zunächst einmal möglichst auf einer Linie liegen, um einen sich entlang dem integrierten Widerstand r ändernden Potentialverlauf einstellen zu können. Dann erst wird entsprechend der Erfindung das Kontaktpaar 3 und 4 der Wanne mit den beiden Klemmen des Ausgangs einer Stromquelle oder auch einer Spannungsquelle verbunden, welche zumindest während des Flusses eines Stromes im integrierten Widerstand r einen bestimmten Stromfluß durch die Wanne bewirkt, der aber von dem Stromfluß des Widerstandes r getrennt sein muß und einen bestimmten Potentialverlauf bewirkt.

In der Fig. 1a ist der Potentialverlauf Ø r(x) entlang dem integrierten Widerstand r aufgetragen, an dem die Spannung Ur anliegt. An den Wannen von herkömmlichen integrierten Widerständen liegt dagegen normalerweise ein entlang der Längserstreckung x sich nicht änderndes Potential Ø (w). Gleiches gilt für das Potential des Substrates Ø s(x). Dieser Sachverhalt wird von der Fig. 1a veranschaulicht, während die Fig. 1 b die Potentialverhältnisse zeigt, wie sie an einem integrierten Widerstand der monolithischen Schaltung nach der Erfindung auftreten.

Durch das Anbringen eines zweiten Kontaktes an der Wanne in Verlängerung der Längsrichtung des integrierten Widerstandes ergibt sich nämlich die Möglichkeit, einen bestimmten Potentialverlauf der Wanne w entlang dem integrierten Widerstand r einzustellen, beispielsweise auch einen solchen entsprechend der Fig. 1 b, so daß der Potentialverlauf Ø w(x) der Wanne w in einem im wesentlichen konstanten Abstand C entlang dem Potentialverlauf Ø r(X) verläuft. Die drei Potentialverläufe entlang der Wanne w, entlang dem integrierten Widerstand r und dem Substrat s sind zueinander so auszurichten, daß die beiden PN-Übergangsflächen 5 und 6 im Betrieb stets in Sperrichtung vorgespannt werden; Ø r(x) muß also unterhalb von Ø w(x) und oberhalb von Ø s(x) verlaufen. Im übrigen sind in den Fig. 1 a und 1 b die Randeffekte der Potentiale an den Kontakten vernachlässigt, da sie von höherer Ordnung sind.

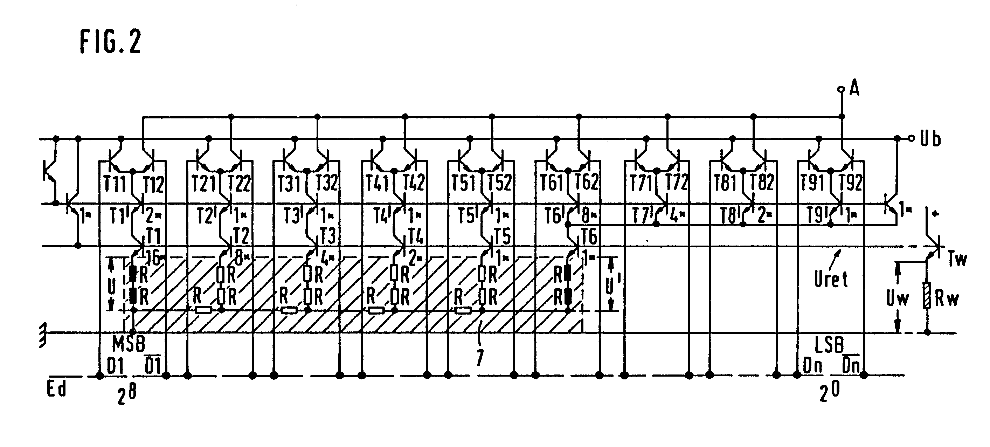

Die Fig. 2 zeigt das Schaltbild eines 9-Bit-D/A-Stromwandlers, der ein R-2R-Netzwerk mit nichtgeschalteten Widerständen enthält, welche entsprechend der Lehre der Erfindung in Wannen einer Wannenstruktur untergebracht werden können, welche der Widerstandsnetzwerkstruktur angepaßt ist. Der D/A-Stromwandler gemäß der Fig. 9 ist bis auf den im rechten Teil der Fig. 2 gestrichelt angeschlossenen Stromquellen-Wannentransistor Tw bekannt, so daß eine nähere Beschreibung von Aufbau und Wirkungsweise entbehrlich ist. Jedenfalls werden entsprechend den zueinander komplementären Eingangssignalen D1, D̄1; ...; Dn, D̄n des digitalen Eingangs Ed die entsprechend den Bits gewichteten Ströme entweder über die Schaltertransistoren T11 bis T91 in die Spannungsquelle Up oder über die Schaltertransistoren T12...T91 in den Ausgang A eingespeist. Die Wichtung der Ströme erfolgt entsprechend den an den Stromquellentransistoren T1 bis T6 bzw. T1' bis T9' angegebenen Faktoren, wobei die Emitter der unteren Stromquellentransistoren T1 bis T6 an die oberen Anschlüsse der 2R-Widerstände angeschlossen sind.

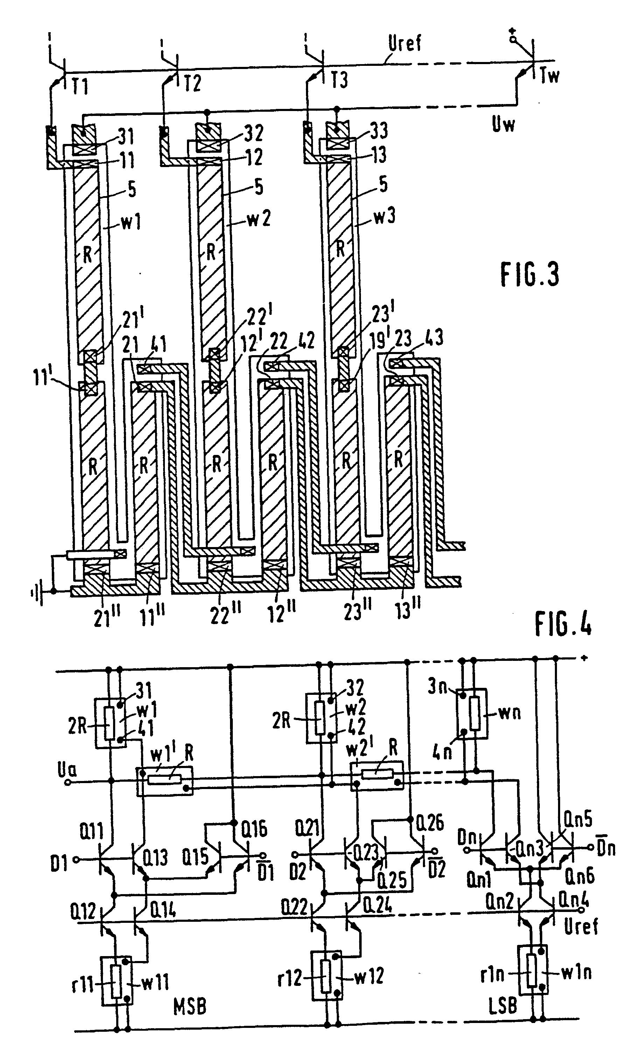

Werden nun die gleichgroßen Widerstände R gemeinsam in der schräg gestrichelten Wanne 7 untergebracht, so liegt an den beiden linken Widerständen eine weit höhere Spannung U an als die Spannung U' an den Widerständen auf der rechten Seite des Netzwerks. Selbst bei topologisch gleicher Auslegung der Widerstände R, welche auch zum Zwecke der Erzielung von gleichen Werten gemeinsam diffundiert werden, sind die Widerstandswerte aufgrund der Sperrspannungsabhängigkeit der PN-Übergangsfläche zwischen dem Widerstand und der Wanne unterschiedlich. Zur Behebung dieses Nachteils eignet sich die Lehre der Erfindung, indem zunächst einmal ein zusätzlicher Stromquellen-Wannentransistor Tw vorgesehen ist, dessen Kollektor an der Spannungsversorgung, dessen Basis mit der an den weiteren Stromquellentransistoren T1 bis T6 liegenden Spannungsquelle der Referenzspannung Uref liegt und dessen Emitter über das Wannennetzwerk Rw mit Masse verbunden ist, wie die Fig. 3 veranschaulicht.

Die Wannen w1 bis wn des Wannennetzwerkes, wovon die ersten drei Wannen w1 bis w3 in der Fig. 3 gezeigt werden, zeichnet sich dadurch aus, daß drei R-Widerstände in einer gemeinsamen Wanne angeordnet sind. Die Ähnlichkeitsforderung der Lehre nach der Erfindung ist also insofern eingeschränkt, als eine Ähnlichkeit wohl in Längsrichtung der Widerstände, nicht aber unbedingt in Querrichtung erforderlich ist, daß also wohl der seitliche Rand der Wanne dem seitlichen Rand des Widerstandes folgen soll, nicht aber unbedingt dem Rand des Widerstandes an dessen Enden. Es dürfte einleuchten, daß auch nach dieser Einschränkung die Lehre der Erfindung vollziehbar ist, da es natürlich auf den Potentialverlauf in Längsrichtung der Widerstände ankommt. Aufgrund dieser Überlegung ergibt sich die in Längsrichtung der Widerstände ununterbrochene Wannenstruktur der Fig. 3 für jeweils drei R-Widerstände, wodurch sich der bemerkenswerte Vorteil ergibt, daß der Kontaktierungsaufwand zur Hintereinanderschaltung der sonst erforderlichen drei Wannen anstelle von einer entfällt. Als Kontaktierungsaufwand für jede der Wannen w1 bis w3... verbleibt nämlich lediglich das Anbringen von Endkontakten 31, 32, 33,...; 41, 42, 43,... gemäß der Fig. 3 und das Anbringen von Kontakten an den an den Enden der R-Widerstände angebrachten, in der Fig. 3 durchkreuzten Kontaktierungsbereichen 11, 12, 13; 21', 22', 23';...; 11', 12', 13'; 21'', 22'', 23'',...; 21, 22, 23.... Die einzelnen Wannen w1, w2, w3,... liegen, wie die Fig. 3 zeigt, parallel geschaltet am Emitter des Stromquellen-Wannentransistors Tw an der konstanten Wannenspannung Uw.

Fig. 4 veranschaulicht die Anwendung der Lehre der Erfindung auf einen D/A-Spannungswandler und zeigt den Ausschnitt des schaltbaren R-2R-Netzwerkes mit den dementsprechend schaltbar ausgebildeten Wannen w1, w2... wn, w2',... des ebenfalls schaltbar ausgebildeten Wannennetzwerkes. In der Schaltung der Fig. 2 sind diese Wannen, wie auch die weiteren Wannen w11, w12..., w1n der Emitterwiderstände r11, r1n... der Stromquellentransistoren Q12 bis Qn4 dargestellt. Die Wannen des Wannennetzwerkes bilden, wie die Fig. 4 ohne weiteres erkennen läßt, nicht nur das gleiche Widerstandsnetzwerk nach, sie sind auch noch in gleicher Weise wie das Widerstandsnetzwerk schaltbar, indem für jeden der Wannen des Wannennetzwerkes Schaltertransistoren Q13, Q15; Q23, Q25; ...; Qn3, Qn5 bzw. Stromquellentransistoren Q14, Q24... Qn4 wie im Widerstandsnetzwerk vorgesehen sind, wobei die Steuerelektrode der äquivalenten Schaltertransistoren, beispielsweise Q11, Q13 oder Q12 mit Q14, parallel geschaltet sind.

Das Wannennetzwerk eines D/A-Spannungswandlers gemäß der Fig. 4 ist selbst ein R-2R-Netzwerk, das im wesentlichen gleichzeitig schaltbar ist. Bei schnellen D/A-Spannungswandlern ist jedoch eine Berücksichtigung der Ein- und Ausschaltzeiten erforderlich, in die sowohl die über die Länge der integrierten Widerstände als auch über die Länge der Wannen aufsummierten RC-Produkte eingehen. Die Längswiderstandswerte der Wannen sollten daher jeweils an die Längswiderstandswerte der einzelnen in ihnen befindlichen Widerstände r angepaßt werden.

**Patentansprüche**

1. Monolithisch integrierte Schaltung mit mindestens einem integrierten Widerstand des ersten Leitungstyps in einer halbleitenden Wanne (w) des zweiten Leitungstyps, welche in eine Oberflächenseite eines keine Epitaxsschicht aufweisenden Substrats (s) des ersten Leitungstyps eingesetzt ist, wobei in Längsrichtung (x) des integrierten Widerstandes (r) sowohl an dessen Enden als auch an den Enden der Wanne (w) je ein Kontaktpaar (1, 2; 3, 4) angebracht sind, an die zumindest zeitweilig die Ausgangsspannung (Uw) je einer Strom- oder Spannungsquelle angelegt wird,

dadurch gekennzeichnet,

- daß das Kontaktpaar (3, 4; 31, 41; 32, 42;...) der Wanne (w) mit dem Ausgang einer Strom- oder Spannungsquelle verbunden ist, deren Ausgangsspannung (Uw) zumindest während des Flusses eines Stromes durch den integrierten Widerstand (r) einen von dem Stromfluß des Widerstandes getrennten Stromfluß durch die Wanne (w) bewirkt, so daß der Potentialverlauf (Ø w) der Wanne (w) in Längsrichtung (x) des integrierten Widerstandes (r) dem Potentialverlauf (Ø r) entlang dem integrierten Widerstand (r) weitgehend bis auf eine konstante Potentialdifferenz (C) angenähert ist, welche die PN-Übergangsfläche (5) zwischen der Wanne (w) und dem integrierten Widerstand (r) in Sperrichtung vorgespannt hält.

2. Monolithisch integrierte Schaltung nach Anspruch 1, dadurch gekennzeichnet, daß das Kontaktpaar (3, 4; 31, 41; 32, 42;...) der Wanne (w; w1, w2,...) im Stromkreis einer umschaltbaren Strom- oder Spannungsquelle (Q13, Q14; Q15; Q23, Q24, Q25;... Qn3, Qn4, Qn5) liegt, welche gleichzeitig mit dem Stromfluß durch den integrierten Widerstand (w; w1,... wn) schaltbar ist.

3. Monolithisch integrierte Schaltung nach Anspruch 1 oder Anspruch 2, gekennzeichnet, durch ein Widerstandsnetzwerk, dessen Widerstände einzeln oder mehrfach in je eine Wanne (w1, w2, w3,...) einer der Widerstandsnetzwerkstruktur topologisch ähnlichen Wannenstruktur eingesetzt sind, deren Wannen in gleicher Weise zu einem Wannennetzwerk verbunden sind wie die Widerstände des Widerstandsnetzwerkes. (Fig. 3)

4. Monolithisch integrierte Schaltung nach Anspruch 3, dadurch gekennzeichnet, daß das Wannennetzwerk mittels Schaltern (Q13, Q15; Q23, Q25;...; Qn3, Qn5) in gleicher Weise wie das Widerstandsnetzwerk schaltbar ist. (Fig. 4)

**Revendications**

1. Circuit intégré monolithique comprenant au moins une résistance intégrée du premier type de conductibilité dans un caisson semi-conducteur (w) du second type de conductibilité formé dans une partie de la surface d'un substrat (s) du premier type de conductibilité et sans couche épitaxiale, avec deux paires de contacts (1, 2; 3, 4) prévues, respectivement, dans la direction longitudinale (x) de la résistance intégrée (r), aux extrémités de la résistance intégrée (r) et aux extrémités du caisson (w), à chacune desquelles est connectée, au moins temporairement, la tension de sortie (Uw) d'une source de courant ou de tension,

caractérisè en ce que:

- la paire de contact (3, 4; 31, 41; 32, 42...) du caisson (w) est connectée à la sortie d'une source de courant ou de tension dont la tension de sortie (Uw) provoque, au moins durant l'écoulement du courant dans la résistance intégrée (r), l'écoulement d'un courant au travers du caisson (w) séparé du courant s'écoulant à travers la résistance, de sorte que le profil de potentiel (Øw) du caisson (w), dans la direction longitudinale (x) de la résistance intégrée (r), s'approche étroitement du profil de potentiel (Ør) le long de la résistance intégrée (r) jusqu'à une différence de potentiel constante (C), laquelle maintient la polarisation inverse de la jonction PN (5) entre le caisson (w) et la résistance intégrée (r).

2. Circuit intégré monolithique selon la revendication 1, caractérisé en ce que la paire de contacts (3, 4; 31, 41; 32. 42...) du caisson (w; w1: w2...) est incluse dans le circuit d'une source de courant ou de tension commutable (Q13, Q14; Q15; Q23, Q24, Q25...; Qn3, Qn4, Qn5) qui peut être commutée en même temps que le courant s'écoulant à travers la résistance intégrée (R;2R; r11...,r1n).

3. Circuit intégré monolithique selon la revendication 1 ou 2, caractérisé par un réseau de résistances dont les résistances sont formées, indivuellement ou par groupes, dans les caissons (w1, w2, w3...) d'une structure de caissons qui est topologiquement similaire à la structure du réseau de résistances et dont les caissons sont interconnectés pour former un réseau de caissons de la même manière que les résistances du réseau de résistances (fig. 3.)

4. Circuit intégré monolithique selon la revendication 3, caractérisé en ce que le réseau de caissons est commutable par des commutateurs (Q13, Q15; Q23, Q25...; Qn3, Qn5) de la même manière que le réseau de résistances (fig. 4).

**Claims**

1. Monolithic integrated circuit comprising at least one integrated resistor of the first conductivity type in a semiconducting well (w) of the second conductivity type which is formed in one surface portion of a substrate (s) of the first conductivity type and without any epitaxial layer with two contact pairs (1, 2; 3, 4) provided, respectively, at the ends of the integrated resistor (r) and at the ends of the well (w) in the longitudinal direction (x) of the integrated resistor (r), each of said contact pairs being connected, at least temporarily, to the output voltage (Uw) of a current or voltage source associated therewith,

characterized in

- that the contact pair (3, 4; 31, 41; 32, 42;...) of the well (w) is connected to the output of a current or voltage source whose output voltage (Uw) causes, at least during the flow of current through the integrated resistor (r), a current flow through the well (w) separated from the current flow through the resistor, so that the potential profile (Øw) of the well (w) in the longitudinal direction (x) of the integrated resistor (r) is closely approximated to the potential profile (Ør) along the integrated resistor (r) up to a constant potential difference (C) which keeps the PN junction (5) between the well (w) and the integrated resistor (r) reverse-biased.

2. A monolithic integrated circuit as claimed in claim 1, characterized in that the contact pair (3, 4; 31, 41; 32, 42;...) of the well (w; w1, w2,...) lies in the circuit of a switchable current or voltage source (Q13, Q14; Q15; Q23, Q24, Q25;... Qn3, Qn4, Qn5) which is switchable simultaneously with the current flow through the integrated resistor (R; 2R; r11,... r1n).

3. A monolithic integrated circuit as claimed in claim 1 or 2, characterized by a resistor network whose resistors are formed, singly or in groups of two or more, in the wells (w1, w2, w3,...) of a well structure which is topologically similar to the resistor network structure and whose wells are interconnected to form a well network in the same manner as the resistors of the resistor network (Fig. 3).

4. A monolithic integrated circuit as claimed in claim 3, characterized in that the well network is switchable by means of switches (Q13, Q15; Q23 Q25..... Qn3 Qn5) in the same manner as the resistor network (Fig. 4).

# FIG.1

FIG.2

FIG.3

FIG.4